# EUROPEAN PATENT APPLICATION

(11) **EP 4 145 649 A1**
(43) Date of publication of application: **08.03.2023**
(21) Application number: 22192544.9
(22) Date of filing: 29.08.2022
(51) Int. Cl.: H01S 5/00, H01S 5/02208, H01S 5/02345, H01L 33/50, H01S 5/068

(54) **LIGHT EMITTING DEVICE**

(30) Priority: 02.09.2021 JP 2021143032
(71) Applicant: Nichia Corporation, Anan-shi, Tokushima 774-8601 (JP)
(72) Inventor: MIURA, Soichiro, Anan-shi, 774-8601 (JP)
(74) Representative: Betten & Resch

(57) **Abstract**

A light emitting device (200) includes: a package (210) including a base portion (211), a frame portion (212), and a cover portion (213); a light emitting element disposed (220) on an upper surface of the base portion, surrounded by the frame portion, and configured to emit light traveling laterally; and a wavelength conversion member (240) disposed on the base portion and including a first lateral surface (241c) on which light emitted from a light extraction surface of the light emitting element is to be incident, and an upper surface (241a) through which light is to be emitted. The frame portion (212) includes a light shielding portion configured to shield light in a wavelength range of the light emitted from the light emitting element. The cover portion includes a light-transmissive portion (213t) configured to transmit and cause light emitted from the upper surface of the wavelength conversion member to exit to an area outside the light emitting device.

## Description

### BACKGROUND

### 1. Technical Field

The present disclosure relates to a light emitting device.

### 2. Description of Related Art

Japanese Patent Application Publication No. 2020-144363 A discloses a light emitting device in which light emitted from a plurality of semiconductor laser elements is reflected at a light reflecting member and incident on a light transmitting portion, and the light incident on the light transmitting portion is converted into light having a different wavelength by the light transmitting portion and is emitted to the outside.

Further, in consideration of safety, this light emitting device is provided with a safety measure when an abnormality such as a crack occurs in the light transmitting portion. Specifically, the light transmitting portion is surrounded by a conductive film and provided with a sensor that detects abnormalities in the light transmitting portion by detecting changes in an electrical connection state that occur in the conductive film.

The more components constituting a light emitting device, the larger in size the light emitting device tends to be. In addition, when high-functionality and multi-functionality, such as high output characteristics and safety measures, are pursued, the number of required components also tends to increase. Despite such circumstances, there is a desire to miniaturize such a light emitting device while maintaining a balance with functionality.

### SUMMARY

The present disclosure includes the following aspects.

A light emitting device according to an embodiment of the present disclosure includes a package including a base portion, a frame portion, and a cover portion; a light emitting element disposed on an upper surface of the base portion, surrounded by the frame portion, and configured to emit light traveling laterally; and a wavelength conversion member disposed on the base portion and including a first lateral surface on which light emitted from a light extraction surface of the light emitting element is to be incident, and an upper surface through which light is to be emitted, the frame portion including a light shielding portion configured to shield light in a wavelength range same as that of the light emitted from the light emitting element, the cover portion including a light-transmissive portion configured to transmit and cause light emitted from the upper surface of the wavelength conversion member to exit to the outside, the light shielding portion being located on an extending line of an optical path of a main portion of light emitted from the light extraction surface, the optical path extending most upwardly from emission from the light extraction surface to incidence on the wavelength conversion member, and the light-transmissive portion not being disposed on a line segment on the extending line of the optical path of the main portion of light, the optical path extending most upwardly from emission from the light extraction surface to incidence on the wavelength conversion member, the line segment being a portion between the light extraction surface of the light emitting element and the intersection with the light shielding portion.

According to one embodiment of the present disclosure, a light emitting device that can be miniaturized can be provided. Further, according to one embodiment of the present disclosure, miniaturization of a light emitting device in which safety is ensured can be achieved.

### BRIEF DESCRIPTION OF DRAWINGS

FIG. 1 is a schematic perspective view illustrating an example of a light emitting device according to one embodiment.
FIG. 2 is a schematic perspective view for describing an internal structure of the light emitting device according to one embodiment.
FIG. 3 is a schematic top view for describing the internal structure of the light emitting device according to one embodiment.
FIG. 4 is a schematic cross-sectional view taken along line IV-IV in FIG. 3, illustrating an example of the light emitting device according to one embodiment.
FIG. 5 is a schematic diagram (No. 1) illustrating an example of a method of manufacturing an optical member according to one embodiment.
FIG. 6 is a schematic diagram (No. 2) illustrating an example of the method of manufacturing the optical member according to one embodiment.
FIG. 7 is a schematic diagram (No. 3) illustrating an example of the method of manufacturing the optical member according to one embodiment.
FIG. 8 is a schematic diagram (No. 4) illustrating an example of the method of manufacturing the optical member according to one embodiment.
FIG. 9 is a schematic diagram (No. 5) illustrating an example of the method of manufacturing the optical member according to one embodiment.
FIG. 10 is a schematic diagram (No. 6) illustrating an example of the method of manufacturing the optical member according to one embodiment.
FIG. 11 is an enlarged partial schematic view of FIG. 3.
FIG. 12 is a schematic diagram for describing a light shielding portion.

### DETAILED DESCRIPTION

Hereinafter, certain embodiments of the invention will be described with reference to the drawings. In the following description, terms indicating a specific direction or position (e.g., "upper," "lower," and other terms including those terms) are used as necessary. Those terms are used to facilitate understanding of the invention with reference to the drawings, and the technical scope of the invention is not limited by the meaning of those terms. In addition, parts having the same reference numerals appearing in a plurality of drawings indicate identical or equivalent parts or members.

In the present disclosure, for polygonal shapes such as triangles and quadrangles, polygonal shapes with rounded corners, slanted corners, inverse-rounded corners, and the like, are referred to as polygonal shapes. Furthermore, not only shapes with such modification at corners (end of sides) but also shapes with modifications at intermediate portions of sides of the shapes are also referred to as polygons. That is, shapes based on polygonal shapes and partially modified are also within the interpretation of "polygonal shapes" in the present disclosure.

Such interpretation is not only polygonal shapes but also applies to terms denoting specific shapes such as trapezoids, circles, protrusions, and recesses. The same applies to sides forming such shapes. That is, even if an end or an intermediate portion of a side is modified, the modified portion is interpreted as a portion of a "side." When "polygonal shapes" and "sides" without such modified portions are intended to be distinguished from those with modifications, the term "exact" is added, such as an "exact quadrangular shape."

Furthermore, the following embodiments exemplify light emitting devices and the like for embodying the technical concept of the present invention, and the present invention is not limited to the description below. In addition, unless otherwise specified, the dimensions, materials, shapes, relative arrangements, and the like of constituent elements described below are not intended to limit the scope of the present invention to those alone, but are intended to be exemplified. The contents described in one embodiment can be applied to other embodiments and modified examples. The size, positional relationship, and the like of the members illustrated in the drawings can be exaggerated in order to clarify the explanation. Furthermore, in order to avoid excessive complication of the drawings, a schematic view in which some elements are not illustrated may be used, or an end view illustrating only a cut surface may be used as a cross-sectional view.

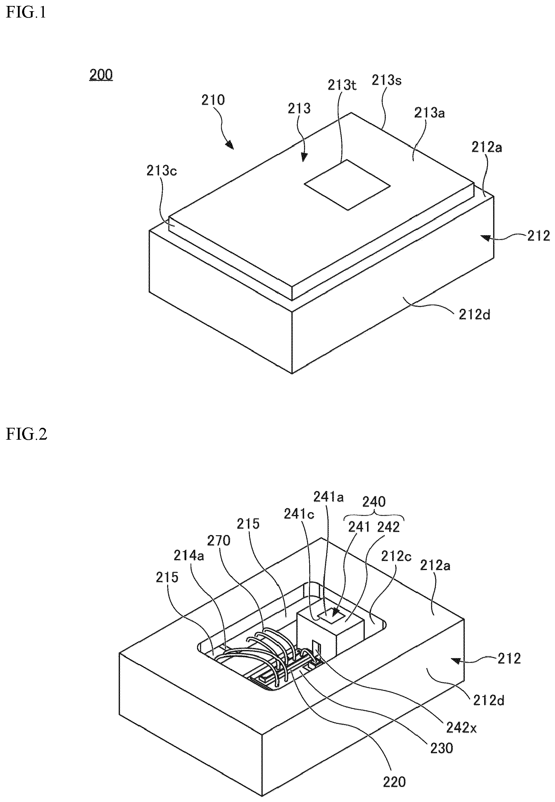

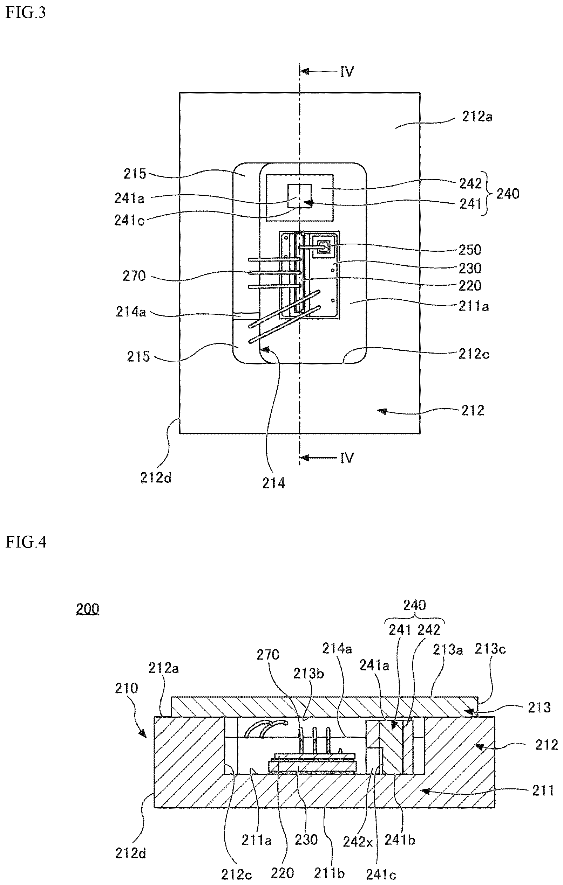

FIG. 1 is a schematic perspective view illustrating an example of a light emitting device according to the present embodiment. FIG. 2 is a schematic perspective view for describing an internal structure of the light emitting device according to the present embodiment. FIG. 3 is a schematic top view for describing the internal structure of the light emitting device according to the present embodiment. FIG. 4 is a schematic cross-sectional view taken along line IV-IV in FIG. 3 illustrating an example of the light emitting device according to the present embodiment.

A light emitting device 200 according to the present embodiment includes a plurality of components. The plurality of components include a package 210, a light emitting element 220, a submount 230, an optical member 240, a protecting element 250, and a wire 270. However, the light emitting device 200 need not include all of these components. For example, the light emitting device 200 including a plurality of components including at least the package 210, the light emitting element 220, and the optical member 240 can be realized.

Components of the light emitting device 200 will be described.

### Package 210

The package 210 includes a base portion 211, a frame portion 212, and a cover portion 213. The base portion 211 includes an upper surface 211a and a lower surface 211b. The base portion 211 has a rectangular outer shape in a top view. This rectangular shape may be a rectangular shape with long sides and short sides. The outer shape of the base portion 211 in a top view need not be a rectangular shape. A rectangular shape may include a square shape unless specifically described as excluding a square shape.

The frame portion 212 includes an upper surface 212a, one or a plurality of inner lateral surfaces 212c, and one or a plurality of outer lateral surfaces 212d. The frame portion 212 has, for example, a rectangular frame shape in a top view. The one or the plurality of inner lateral surfaces 212c of the frame portion 212 meet the upper surface 211a of the base portion 211. The one or the plurality of outer lateral surfaces 212d of the frame portion 212 meet the upper surface 212a of the frame portion 212.

The base portion 211 and the frame potion 212 each have a recessed shape recessed in a direction from the upper surface 212a of the frame portion 212 to the upper surface 211a of the base portion 211. The recessed shape is formed at a location inward of the outer shape of the frame portion 212 in a top view. In a top view, the upper surface 211a of the base portion 211 is surrounded by a frame formed by the one or the plurality of inner lateral surfaces 212c of the frame portion 212. An outer shape of this frame is a rectangular shape having long sides and short sides. The base portion 211 and the frame portion 212 can be integrally formed. The base portion 211 and the frame portion 212 may be separately formed and these may be joined together.

The term "top view" in the present specification refers to viewing an object from a normal direction of the upper surface 211a of the base portion 211. Further, the shape of an object viewed from the normal direction of the upper surface 211a of the base portion 211 may be referred to as a "planar shape."

The package 210 may include a stepped portion 214 including an upper surface 214a located above the upper surface 211a of the base portion 211 and below the upper surface 212a of the frame portion 212. The stepped portion 214 is formed at a location inward of the frame. For example, the stepped portion 214 is constituted only by an upper surface 214a and a lateral surface that meets the upper surface 214a and faces downward. The upper surface 214a of the stepped portion 214 is, for example, parallel with the upper surface 211a of the base portion 211. The lateral surface of the stepped portion 214 meets the upper surface 211a of the base portion 211, for example. The stepped portion 214 may be provided on one of the inner lateral surfaces 212c of the frame portion 212 opposite to each other at locations inward of the frame, and need not be provided on the other of the inner lateral surfaces 212c opposite to each other. The stepped portion 214 is formed to extend along the inner lateral surface 212c. For example, on one inner lateral surface 212c of all inner lateral surfaces 212c constituting the frame, the stepped portion 214 is formed to have a length of 50% or greater of that of the inner lateral surface 212c along the inner lateral surface 212c in a top view.

One or a plurality of metal films 215 may be provided on the upper surface 214a of the stepped portion 214. Further, one or a plurality of metal films may be provided on the upper surface 212a of the frame portion 212. The one or the plurality of metal films 215 provided on the upper surface 214a of the stepped portion 214 may include the metal film 215 electrically connected to the metal film provided on the upper surface 212a. For the metal film 215 and the metal film provided on the upper surface 212a, Ni/Au (metal film layered in the order of Ni, Au), or Ti/Pt/Au (metal film layered in the order of Ti, Pt, Au), for example, can be used.

The cover portion 213 includes an upper surface 213a, a lower surface 213b, and one or a plurality of lateral surfaces 213c that meet the upper surface 213a and the lower surface 213b. The one or the plurality of lateral surfaces 213c connect an outer edge of the upper surface 213a and an outer edge of the lower surface 213b. The cover portion 213 has, for example, a rectangular parallelepiped shape or a cubic shape. In this case, both the upper surface 213a and the lower surface 213b of the cover portion 213 have a rectangular shape, and the cover portion 213 has four rectangular-shaped lateral surfaces 213c.

However, the cover portion 213 is not limited to have a rectangular parallelepiped or cubic shape. That is, the cover portion 213 is not limited to have a rectangular shape in a top view, and can have any shape such as a circle, an oval, or a polygon.

The cover portion 213 is supported by the frame portion 212 and is disposed above the upper surface 211a of the base portion 211. An outer peripheral portion of the lower surface 213b of the cover portion 213 is joined to the upper surface 212a of the frame portion 212, for example. With the cover portion 213 being joined to the frame portion 212, a closed space is formed in the package 210.

The base portion 211 and the frame portion 212 can be formed of, for example, a ceramic as a main material. For example, aluminum nitride, silicon nitride, aluminum oxide, or silicon carbide can be used as the ceramic. The base portion 211 and the frame portion 212 are not limited to be formed of a ceramic, and may be formed using other materials having insulating properties as the main material.

The cover portion 213 includes a light-transmissive portion 213t that transmits light having a predetermined wavelength. The light-transmissive portion 213t constitutes a portion of the upper surface 213a and the lower surface 213b of the cover portion 213. The light-transmissive portion 213t of the cover portion 213 can be formed using sapphire as a main material, for example. Sapphire is a material with relatively high transmittance and relatively high strength. Other than sapphire, examples of a material to be used as the main material of the light-transmissive portion 213t of the cover portion 213 include light-transmissive materials such as quartz, silicon carbide, and glass. A portion of the cover portion 213 other than the light-transmissive portion 213t may be formed of the same material as that of the light-transmissive portion 213t, and may be formed integrally with the light-transmissive portion 213t.

Further, the cover portion 213 can include a light shielding portion 213s. The light shielding portion 213s is configured to shield light from entering and exiting. The light shielding portion 213s constitutes a portion of the upper surface 213a or the lower surface 213b of the cover portion 213. The light shielding portion 213s is formed by providing a light shielding film on a surface of the cover portion 213, for example. Further, for example, the light shielding portion 213s may be formed by forming a portion of the cover portion 213 other than the light-transmissive portion 213t using a light shielding material including a metal or the like.

### Light Emitting Element 220

The light emitting element 220 is, for example, a semiconductor laser element. The light emitting element 220 is not limited to a semiconductor laser element, and may be, for example, a light emitting diode (LED) or an organic light emitting diode (OLED). In the light emitting device 200 exemplarily illustrated in FIG. 1 to FIG. 4, a semiconductor laser element is employed as the light emitting element 220.

The light emitting element 220 has, for example, a rectangular outer shape in a top view. Further, a lateral surface that meets one of two short sides of the rectangle is a light extraction surface for light emitted from the light emitting element 220. Further, each of an upper surface and a lower surface of the light emitting element 220 has a larger area than the light extraction surface.

In the example herein, a case in which the light emitting element 220 is a semiconductor laser element will be described. Light (laser beam) emitted from the light emitting element 220 exhibits divergence and an elliptical far field pattern (hereinafter referred to as "FFP") on a plane parallel to the light extraction surface.
As used herein, the FFP is a shape or a light intensity distribution of the emitted light at a position apart from the light extraction surface.

In the elliptical shape of light emitted from the light emitting element 220, a long-diameter direction of the elliptical shape is referred to as a fast axis direction of the FFP, and a short-diameter direction of the elliptical shape is referred to as a slow axis direction of the FFP. The fast axis direction of the FFP in the light emitting element 220 may coincide with a layering direction in which a plurality of semiconductor layers including an active layer of the light emitting element 220 are layered.

Based on the light intensity distribution of the FFP of the light emitting element 220, light having an intensity of 1/e² times or greater of a peak intensity value is referred to as a "main portion of light." In this light intensity distribution, an angle corresponding to the intensity of 1/e² is referred to as a divergence angle. The divergence angle of the FFP in the fast axis direction is greater than the divergence angle of the FFP in the slow axis direction.

Further, light passing through the center of the elliptical shape of the FFP, in other words, light having a peak intensity in the light intensity distribution of the FFP, may be referred to as light traveling on an optical axis or light passing through an optical axis. Further, the optical path of the light traveling on the optical axis is referred to as the optical axis of the light.

As the light emitting element 220, a light emitting element in which an emission peak wavelength of light emitted from the light emitting element 220 is in a range from 320 nm to 530 nm, typically in a range from 430 nm to 480 nm, can be used. Examples of such a light emitting element 220 include a semiconductor laser element including a nitride semiconductor. As the nitride semiconductor, for example, GaN, InGaN, or AlGaN can be used.

The emission peak of the light emitted from the light emitting element 220 need not be limited to this. Further, the light emitting element 220 may emit light having a wavelength outside the wavelength range described above. For example, the light emitted from the light emitting element 220 can be appropriately selected within the range of visible light.

### Submount 230

The submount 230 is configured, for example, in a rectangular parallelepiped shape and includes a lower surface, an upper surface, and one or a plurality of lateral surfaces. The submount 230 has the smallest width in the vertical direction. Note that the shape may not be limited to a rectangular parallelepiped. The submount 230 is formed using, for example, aluminum nitride or silicon carbide, but other materials may be used. Further, a metal film, for example, is disposed on the upper surface of the submount 230.

### Optical Member 240

The optical member 240 includes a light transmitting portion 241 and a light reflecting portion 242. The light transmitting portion 241 includes a transmitting surface that transmits light. The light reflecting portion 242 has a reflecting surface that reflects light. The optical member 240 can be configured to include either one of the light transmitting portion 241 or the light reflecting portion 242.

The light transmitting portion 241 includes an upper surface 241a, a lower surface 241b that is a surface opposite to the upper surface 241a, and one or a plurality of lateral surfaces that meet the upper surface 241a and the lower surface 241b. The one or the plurality of lateral surfaces are connected to an outer edge of the upper surface 241a and an outer edge of the lower surface 241b.

The upper surface 241a and the lower surface 241b of the light transmitting portion 241 both have a rectangular shape. In the light emitting device 200 exemplarily illustrated in FIG. 1 to FIG. 4, the light transmitting portion 241 includes four lateral surfaces including a first lateral surface 241c that is a surface where light is incident.

The first lateral surface 241c includes a lower first lateral surface region and an upper first lateral surface region. The lower first lateral surface region and the upper first lateral surface region may be in the same plane, or may be provided in different planes, such as in a stepped shape, for example. In the example of FIG. 4, the first lateral surface 241c constitutes a surface having a stepped shape, and the lower first lateral surface region connected to the lower surface 241b is recessed with respect to the upper first lateral surface region connected to the upper surface 241a. The first lateral surface 241c is exposed in an opening 242x provided in the light reflecting portion 242. The lower first lateral surface region of the first lateral surface 241c is exposed in the opening 242x provided in the light reflecting portion 242, and the upper first lateral surface region is covered by the light reflecting portion 242 without being exposed.

The light transmitting portion 241 has light transmissivity for transmitting light. The light transmitting portion 241 may have light transmissivity for light in a wavelength range from 400 nm to 760 nm, for example. In the present specification, the phrase "having light transmissivity" means that a transmittance for the light is 80% or higher. In addition, when the light is light in a certain wavelength range, the phrase "having light transmissivity" means that the transmittance for at least the peak wavelength of the light is 80% or higher.

The light transmitting portion 241 is irradiated with light, and thus the light transmitting portion 241 is preferably formed using an inorganic material that is not easily decomposed by light irradiation as a main material. The main material is, for example, a ceramic. The main material may be sapphire or quartz. In a case in which the main material of the light transmitting portion 241 is a ceramic, examples of the ceramic used include aluminum oxide, aluminum nitride, silicon oxide, yttrium oxide, zirconium oxide, and magnesium oxide. The main material of the ceramic is preferably selected from materials having a melting point in a range of 1300°C to 2500°C so that the light transmitting portion 241 is not deformed, discolored by heat, or the like. The light transmitting portion 241 is, for example, a sintered body formed of a ceramic as a main material. The term "main material" refers to a material that occupies the largest ratio of the constituent elements in terms of weight ratio or volume ratio. Further, the "main material" may also include not including other materials as constituent components, that is, forming a constituent component only with the main material.

The optical member 240 may be a wavelength conversion member. In this case, the light transmitting portion 241 may be a wavelength conversion portion containing a phosphor. In a case in which the light transmitting portion 241 is a wavelength conversion portion, the light transmitting portion 241 can, for example, convert light incident from the first lateral surface 241c that is the incident surface into light having a different wavelength, and emit the converted light from the upper surface 241a that is the light extraction surface. The light transmitting portion 241 may emit a portion of the incident light. The light transmitting portion 241 may be configured to convert all the incident light into light having a different wavelength. Alternatively, or in addition to this, an optical film such as a distributed Bragg reflector (DBR) film that transmits wavelength-converted light and reflects incident light may be provided on an upper surface of the wavelength conversion member or the wavelength conversion portion. Thus, a configuration in which light incident on the light transmitting portion 241 is not emitted from the light transmitting portion 241 can be obtained.

When the light transmitting portion 241 is a wavelength conversion portion, the light transmitting portion 241 can be formed by sintering, for example, a phosphor and a light-transmissive material such as aluminum oxide. The content of the phosphor can be in a range from 0.05 vol% to 50 vol% with respect to the total volume of the ceramic. Further, for example, the light transmitting portion 241 may be formed by sintering a powder of the phosphor, that is, using a ceramic substantially consisting of only the phosphor. Furthermore, the light transmitting portion 241 may be formed of a single crystal of a phosphor.

Examples of the phosphor include yttrium aluminum garnet (YAG) activated with cerium, lutetium aluminum garnet (LAG) activated with cerium, silicate activated with europium ((Sr, Ba)₂SiO₄), αSiAlON phosphor, and βSiAlON phosphor.
Among them, the YAG phosphor has good heat resistance.

For example, in a case in which the light transmitting portion 241 includes the YAG phosphor, when blue excitation light is incident from the first lateral surface 241c, white light can be emitted from the upper surface 241a by combining the blue excitation light and yellow fluorescence. Further, for example, in a case in which the light transmitting portion 241 includes the LAG phosphor, blue excitation light can be incident from the first lateral surface 241c, and green fluorescence can be emitted from the upper surface 241a without emitting the blue excitation light.

The light reflecting portion 242 includes an upper surface, a lower surface that is a surface opposite to the upper surface, one or a plurality of inner lateral surfaces connected to an inner edge of the upper surface and an inner edge of the lower surface, and one or a plurality of outer lateral surfaces connecting an outer edge of the upper surface and an outer edge of the lower surface. The light reflecting portion 242 has a reflectivity of light in a range of 80% to 100% on the one or the plurality of inner lateral surfaces.

The light reflecting portion 242 covers at least all the lateral surfaces other than the first lateral surface 241c of the light transmitting portion 241. The light reflecting portion 242 need not cover the first lateral surface 241c of the light transmitting portion 241, for example. In this case, an upper surface of the light reflecting portion 242 is, for example, substantially U-shaped, opening to the first lateral surface 241c side. When having such a U-shaped structure, two outer lateral surfaces of the light reflecting portion 242 and the first lateral surface 241c of the light transmitting portion 241 may form one continuous plane, for example.

As in the light emitting device 200 exemplarily illustrated in FIGS. 2 to 4, the light reflecting portion 242 covers a portion of the first lateral surface 241c of the light transmitting portion 241. The light reflecting portion 242 may include the opening 242x that defines an opening that causes the light from outside the optical member 240 to be incident on the first lateral surface 241c. The opening has, for example, a rectangular shape, but is not limited to a rectangular shape, and can be any appropriate shape such as a circle, an ellipse, or a polygon.

The light reflecting portion 242 may upwardly and laterally cover a region of the first lateral surface 241c of the light transmitting portion 241 where light from outside the optical member 240 is incident. A portion of the lower first lateral surface region and the entire upper first lateral surface region of the first lateral surface 241c are covered by the light reflecting portion 242. In this case, the shape of the upper surface of the light reflecting portion 242 is, for example, a frame shape including an opening on a center side. The opening has, for example, a rectangular shape, but is not limited to a rectangular shape, and can be any shape such as a circle, an ellipse, or a polygon.

The light reflecting portion 242 is, for example, a sintered body formed of a ceramic as a main material. The ceramic used for the main material includes, for example, aluminum oxide, aluminum nitride, silicon oxide, yttrium oxide, zirconium oxide, and magnesium oxide. Among them, aluminum oxide is preferable in view of high reflectivity. The light reflecting portion 242 does not necessarily contain a ceramic as the main material. The light reflecting portion 242 may be formed using, for example, a metal, a composite of a ceramic and a metal, or a resin.

In the optical member 240, the inner lateral surfaces of the light reflecting portion 242 are connected to a portion of the lateral surfaces of the light transmitting portion 241. The upper surface of the light transmitting portion 241 and the upper surface of the light reflecting portion 242 may form, for example, one continuous plane. Further, the lower surface of the light transmitting portion 241 and the lower surface of the light reflecting portion 242 may form, for example, one continuous plane.

In the optical member 240, the light transmitting portion 241 and the light reflecting portion 242 can be integrally formed. The optical member 240 may be formed by separately forming the light transmitting portion 241 and the light reflecting portion 242 and joining them together. The light transmitting portion 241 and the light reflecting portion 242 are, for example, integrally formed of sintered bodies. For example, the integrated sintered body can be formed by forming a sintered body of the light transmitting portion 241 and then forming the sintered body of the light reflecting portion 242 integrally with the light transmitting portion 241. In this case, in each of a forming step of the light transmitting portion 241 and a forming step of the light reflecting portion 242, a ratio of voids (porosity) contained in the sintered body to be formed can also be adjusted. The porosity can be adjusted by a sintering condition (sintering temperature, sintering time, rate of temperature increase), particle size of materials, concentration of a sintering aid, and the like.

For example, in a case in which the light transmitting portion 241 and the light reflecting portion 242 are formed using the same ceramic as the main material, the porosity of the light reflecting portion 242 is made greater than the porosity of the light transmitting portion 241. That is, the optical member 240 is formed such that the light reflecting portion 242 includes more voids than the light transmitting portion 241. In this case, it is preferable to adjust the sintering conditions so that the porosity of the light reflecting portion 242 is about 10%. As a result, a reflecting region made of air is formed at a boundary between the lateral surface of the light transmitting portion 241 and the inner lateral surface of the light reflecting portion 242, and light striking the inner lateral surface of the light reflecting portion 242 from the light transmitting portion 241 side can be reflected to the light transmitting portion 241 side.

The optical member 240 may include an anti-reflective film (for example, an anti-reflective film 243 described below) on the upper surface. The anti-reflective film can be provided on the upper surface 241a of the light transmitting portion 241, or the upper surface 241a of the light transmitting portion 241 and the upper surface of the light reflecting portion 242. Further, the optical member 240 may include a metal film (for example, a metal film 244 described below) on the lower surface 241b of the light transmitting portion 241 and the lower surface of the light reflecting portion 242. Further, the optical member 240 may include a reflective film (for example, a reflective film 245 described below) on the first lateral surface 241c. This reflective film is provided at least on the first lateral surface 241c of the light transmitting portion 241 exposed in the opening 242x.

### Protecting Element 250

The protecting element 250 is a component for protecting specific elements such as semiconductor laser elements. The protecting element 250 is a component for preventing specific elements such as semiconductor laser elements from being broken by an excessive current that may otherwise flow therethrough, for example. For example, a Zener diode formed of Si can be used as the protecting element 250. Further, for example, the protecting element 250 may be a component for measuring temperature so that a specific element does not fail due to the temperature environment. For example, a thermistor can be used as such a temperature measuring element. The temperature measuring element may be disposed near the light extraction surface of the light emitting element 220.

### Wire 270

The wire 270 is composed of a conductor having a linear shape with joint portions at both ends. In other words, the wire 270 includes joint portions to be joined to other components, at both ends of the linear portion. The wire 270 is used for electrical connection between two components. For example, a metal wire can be used as the wire 270. Examples of the metal include gold, aluminum, silver, copper, and tungsten.

### Method of Manufacturing Optical Member 240

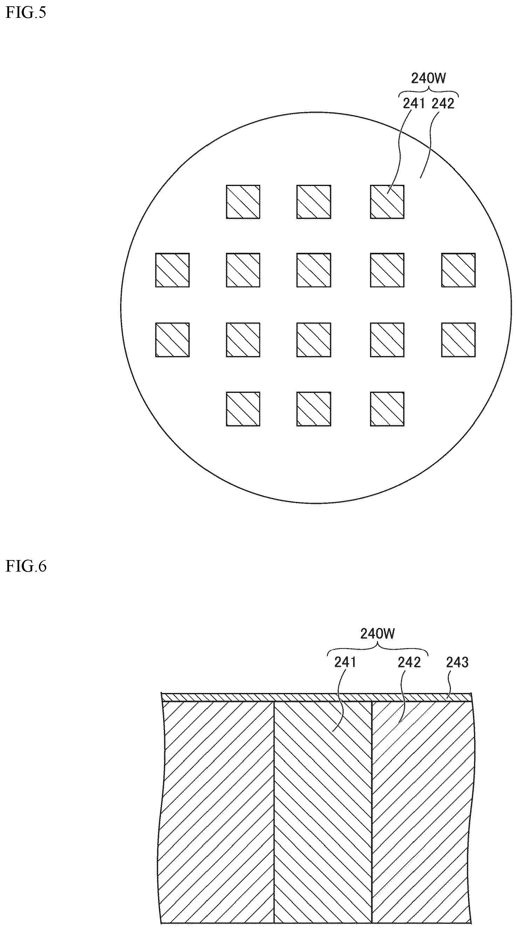

FIGS. 5 to 9 are schematic diagrams illustrating an example of a method of manufacturing the optical member according to the present embodiment. First, as illustrated in FIG. 5, for example, a wafer 240W including a plurality of the light transmitting portions 241 disposed in a matrix shape at a predetermined interval, and one light reflecting portion 242 surrounding the lateral surfaces of each of the light transmitting portions 241, in a top view, is prepared (first step). In the wafer 240W, the upper surface and the lower surface of each of the light transmitting portions 241 are exposed from the light reflecting portion 242. The upper surface of each of the light transmitting portions 241 and the upper surface of the light reflecting portion 242 may form one continuous plane. Further, the lower surface of each of the light transmitting portions 241 and the lower surface of the light reflecting portion 242 may form one continuous plane.

Specifically, first, the plurality of light transmitting portions 241 are prepared, and each of the light transmitting portions 241 is temporarily fixed on a support at a predetermined interval. Each of the light transmitting portions 241 may be a ceramic not containing a phosphor, or may be a ceramic containing a phosphor, for example. Subsequently, a molded body is formed on the support surrounding the upper surfaces and the lateral surfaces of each of the light transmitting portions 241. The molded body includes, for example, a light reflecting powder made of a ceramic as a main material. The molded body can be molded using a slip casting method, a doctor blade method (sheet molding method), a dry molding method, or the like. Subsequently, the support is removed and the light transmitting portions 241 and the molded body are fired at a predetermined temperature. At this time, it is preferable to adjust the sintering conditions of the molded body so that the molded body includes more voids than the light transmitting portions 241. After firing, the molded body covering the upper surfaces of the light transmitting portions 241 is removed by polishing or the like, and the upper surfaces of the light transmitting portions 241 are exposed. Further, as necessary, the lower surface sides of the light transmitting portions 241 and the molded body are flattened by polishing or the like. As a result, the wafer 240W including the plurality of light transmitting portions 241 and one light reflecting portion 242 surrounding the lateral surfaces of each of the light transmitting portions 241 is obtained. Hereinafter, description will be made with reference to a longitudinal cross-sectional view of one light transmitting portion 241 and the light reflecting portion 242 therearound in FIG. 5.

Subsequently, as illustrated in FIG. 6, as necessary, the anti-reflective film 243 may be formed on the entire upper surface of the wafer 240W (second step). The anti-reflective film 243 can be formed, for example, by layering one or a plurality of dielectric multilayer films of, for example, Nb₂O₅/SiO₂, Ta₂O₅/SiO₂, Al₂O₃/SiO₂, ZrO₂/SiO₂, or ZrO₂/Al₂O₃. The anti-reflective film 243 can be formed by, for example, sputtering. With the anti-reflective film 243, it is possible to reduce the internal reflection of light to be emitted from the upper surface of the light transmitting portion 241 to the outside at the upper surface of the light transmitting portion, which allows for increasing the emission efficiency of light emitted from the upper surface of the light transmitting portion 241 to the outside.

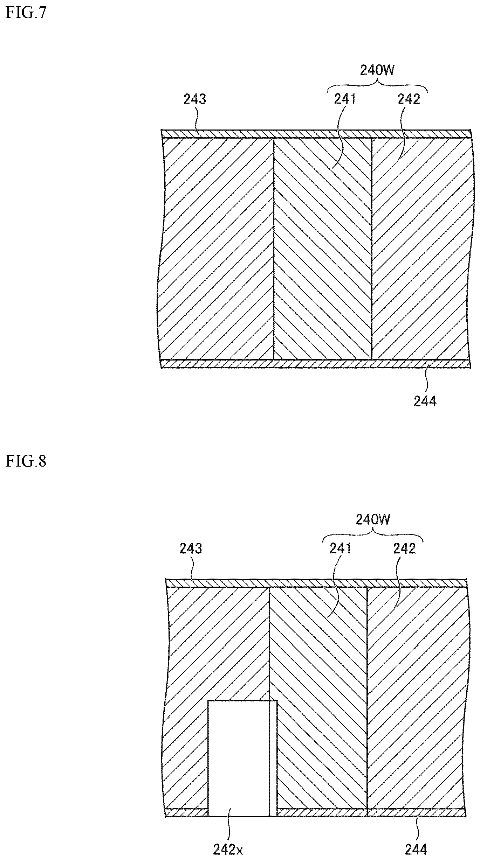

Subsequently, as illustrated in FIG. 7, as necessary, the metal film 244 may be formed on the entire lower surface of the wafer 240W (third step). For the metal film 244, Ti/Ag/Ti/Pt/Au (metal film layered in the order of Ti, Ag, Ti, Pt, Au) or Ti/Al/Ti/Pt/Au (metal film layered in the order of Ti, Al, Ti, Pt, Au) can be used, for example. The metal film 244 can be formed by, for example, sputtering. The metal film 244 can be used when joining the optical member 240 with another member. Further, the metal film 244 provided on the lower surface of the optical member 240 can function as a light reflecting film that upwardly reflects the light that reaches the lower surface of the light transmitting portion 241. Among the metals constituting the metal film 244, Ag or Al is a metal having relatively high reflectivity, making it possible to upwardly reflect the light that reaches the lower surface of the light transmitting portion 241 and thus increase the emission efficiency of light emitted from the upper surface of the light transmitting portion 241 to the outside. Alight reflecting film formed using a material other than metal may be employed instead of the metal film 244. For example, the light reflecting film can be formed by, for example, layering one or a plurality of dielectric multilayer films of, for example, Nb₂O₅/SiO₂, TiO₂/SiO₂, or Ta₂O₅/SiO₂.

Subsequently, as illustrated in FIG. 8, portions of the light transmitting portion 241 and the light reflecting portion 242 are removed without penetrating from the upper surface to the lower surface, and the opening 242x opening to the lower surface side of the wafer 240W is formed (fourth step). For example, portions of the metal film 244, portions of the light transmitting portion 241, and portions of the light reflecting portion 242 are removed by machining from the lower surface side of the wafer 240W to a predetermined height, and the opening 242x opening to the lower surface side of the wafer 240W is formed. This causes a portion of the lateral surface of the light transmitting portion 241 to be exposed in the opening 242x.

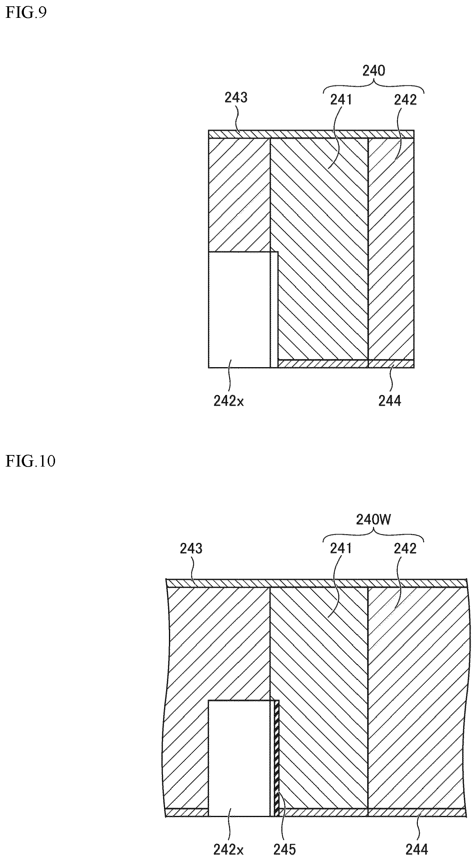

Subsequently, as illustrated in FIG. 9, the light reflecting portion 242 is cut and divided into the plurality of optical members 240 (fifth step). The light reflecting portion 242 is cut so that a portion of the light reflecting portion 242 overlapping the portion removed by the fourth step in a top view remains. In a top view, the light reflecting portion 242 is cut so that the entire periphery of the light transmitting portion 241 surrounds the light reflecting portion 242. The upper surface of the light transmitting portion 241 is entirely surrounded by the light reflecting portion 242, while the lower surface of the light transmitting portion 241 is not partially surrounded by the light reflecting portion 242. In a top view, the light reflecting portion 242 is cut in the vertical direction, passing through the portion removed by the fourth step. The wafer 240W is cut and divided into a plurality of the optical members 240 using a blade, a laser, or the like so that a single optical member 240 includes a single light transmitting portion 241 and a single light reflecting portion 242 surrounding the lateral surfaces of the light transmitting portion 241. For example, in a top view, the light reflecting portion 242 is cut into a lattice shape along an array direction of the light transmitting portions 241.

Note that, as illustrated in FIG. 10, a step of forming the reflective film 245 on the lateral surface of the light transmitting portion 241 exposed in the opening 242x may be provided after the step illustrated in FIG. 8. The reflective film 245 may extend from an upper end of the lateral surface of the light transmitting portion 241 to the light reflecting portion 242 side in the opening 242x. The reflective film 245 is an optical film that reflects light of a particular wavelength and transmits light of other wavelengths. A DBR film is used as the reflective film 245, for example. A DBR film obtained by alternately layering films having different refractive indices at a 1/4 wavelength thickness, for example, can reflect a predetermined wavelength at high efficiency. The DBR film can contain at least one type of oxide or nitride of a material selected from the group consisting of, for example, Si, Ti, Zr, Nb, Ta, and Al. In a case in which the optical member 240 is a wavelength conversion member, by providing the reflective film 245, it is possible to transmit light incident on the wavelength conversion member from the outside to the light transmitting portion 241 side serving as the wavelength conversion portion, and reflect at least 90% of the light converted by the wavelength conversion portion.

### Light Emitting Device 200

In the light emitting device 200, the submount 230 is disposed on the upper surface 211a of the base portion 211. The lower surface of the submount 230 is joined to the upper surface of the metal film formed on the upper surface 211a of the base portion 211, for example.

The light emitting element 220 is disposed on the upper surface 211a of the base portion 211 and is surrounded by the frame portion 212. The light emitting element 220 disposed on the upper surface 211a emits light that travels laterally. Specifically, the light emitting element 220 is disposed on the submount 230, and is disposed on the base portion 211 with the submount 230 interposed therebetween.

The light emitting element 220 is disposed such that the light extraction surface is oriented in a same direction as one lateral surface of the submount 230. Further, the light extraction surface of the light emitting element 220 is, for example, parallel or perpendicular to the inner lateral surface 212c or the outer lateral surface 212d of the frame portion 212.

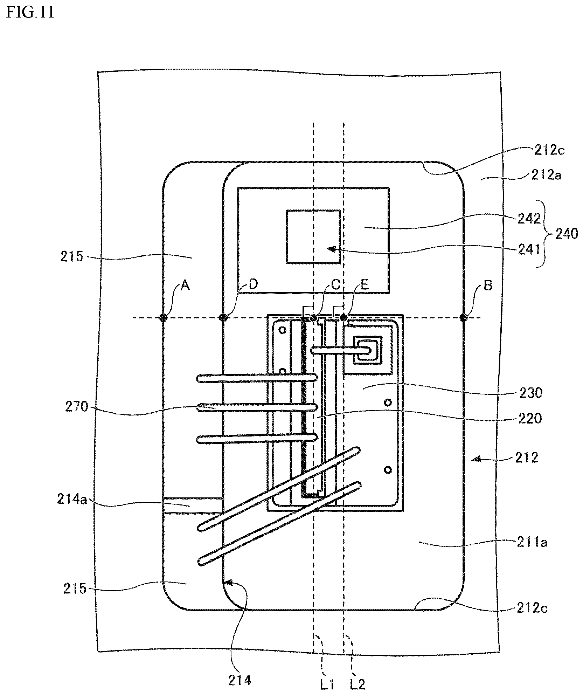

Further, as illustrated in FIG. 11, the light emitting element 220 is disposed at a position through which a virtual line L1 passes, the virtual line L1 being orthogonal to the light extraction surface and passing through a center C between two points A and B at which a plane through which the light extraction surface of the light emitting element 220 extends and a frame defined by the upper surface 212a of the frame portion 212 intersect, in a top view, for example. The upper surface of the light emitting element 220 may be symmetric with respect to the virtual line L1. That is, the light emitting element 220 is disposed, for example, in the center of the frame in a direction parallel to the light extraction surface, in a top view. The two lateral surfaces of the light emitting element 220 that meet the light extraction surface are, for example, parallel to the virtual line L1.

The points A and B can each be referred to as an intersecting point between the plane extending along the light extraction surface of the light emitting element 220 and an inner lateral surface 212c in a top view. The inner lateral surface 212c with the point A and the inner lateral surface 212c with the point B face each other. Both of the inner lateral surfaces 212c are not lateral surfaces of the stepped portion 214.

Alternatively, points A and B can each be an intersecting point between the virtual line orthogonal to the optical axis of the light emitted from the light emitting element 220 and the inner lateral surface 212c in a top view. The inner lateral surface 212c with the point A and the inner lateral surface 212c with the point B face each other. Both of the inner lateral surfaces 212c are not lateral surfaces of the stepped portion 214.

Further, as illustrated in FIG. 11, the light emitting element 220 is disposed at a position where a virtual line L2 does not pass, the virtual line L2 being orthogonal to the light extraction surface and passing through a center E between two points D and B, in a top view, for example. In a top view, the point D is a point where the plane through which the light extraction surface of the light emitting element 220 extends and the lateral surface of the stepped portion 214 intersect. The point B is a point where the inner lateral surface 212c facing the lateral surface of the stepped portion 214 with the light emitting element 220 disposed therebetween and the plane through which the light extraction surface of the light emitting element 220 extends intersect.

The stepped portion 214 is provided on only one side of the virtual line L1, and is not provided on the other side of the virtual line L1. The stepped portion 214 is provided at a position facing one lateral surface of two lateral surfaces of the light emitting element 220 that meet the light extraction surface, and is not provided at a position facing the other lateral surface. This allows for miniaturizing the light emitting device 200 to a greater extent than when the stepped portion is provided on both of these lateral surfaces.

One lateral surface of the two lateral surfaces of the light emitting element 220 that meet the light extraction surface faces the lateral surface of the stepped portion 214. The one lateral surface of the two lateral surfaces of the light emitting element 220 that meet the light extraction surface is, for example, parallel to the lateral surface of the stepped portion 214. The other lateral surface of the two lateral surfaces of the light emitting element 220 that meet the light extraction surface faces the inner lateral surface 212c of the frame portion 212 and does not face the lateral surface of the stepped portion 214. The other lateral surface of the two lateral surfaces of the light emitting element 220 that meet the light extraction surface is, for example, parallel to one of the inner lateral surfaces 212c of the frame portion 212.

A height of the upper surface 214a of the stepped portion 214 is greater than a height of the upper surface of the light emitting element 220, with respect to the upper surface 211a of the base portion 211, for example. The lateral surface of the stepped portion 214 is, for example, parallel to one inner lateral surface 212c of the frame portion 212 facing the lateral surface with the virtual line L1 disposed therebetween.

The light emitting element 220 is disposed on the submount 230 in a region closer to the stepped portion 214 than is the center of the submount 230 in a direction parallel to the light extraction surface, in a top view, for example. In a top view, in a direction parallel to the light extraction surface, a distance between the light emitting element 220 and the stepped portion 214 is less than a distance between a center of the submount 230 and the stepped portion 214. By disposing the light emitting element 220 closer to the stepped portion 214, it is possible to dispose the light emitting element 220 in the center of the package 210. The protecting element 250 may be disposed on the upper surface of the submount 230. The protecting element 250 is disposed, for example, on a side of the light emitting element 220 opposite to the stepped portion 214, in a top view.

The submount 230 on which the light emitting element 220 is disposed can serve as a heat dissipation member that dissipates heat generated from the light emitting element 220 in the light emitting device 200. To cause the submount 230 to function as the heat dissipation member, the submount 230 may be formed of a material having a thermal conductivity better than that of the light emitting element 220. On the upper surface of the submount 230, an area of a region positioned on the side of the virtual line L1 opposite to the stepped portion 214 is greater than an area of a region positioned on the stepped portion 214 side of the virtual line L1. Thus, with the submount 230 extending to the side where the stepped portion 214 is not provided, it is possible to expand the area of the upper surface and the lower surface of the submount 230 and thus improve heat dissipation performance. Further, space for disposing the protecting element 250 can be ensured.

In the light emitting device 200, the light emitting element 220 and the protecting element 250 are electrically connected to the base portion 211 by the wire 270. The wire 270 in the illustrated light emitting device 200 is an example in which the protecting element 250 is a Zener diode, but in a case in which the protecting element 250 is a temperature measuring element, the connection of the wire 270 may be different from the drawing.

The light emitting element 220 is electrically connected to the metal film 215 disposed on the upper surface 214a of the stepped portion 214 via the wire 270. The wire 270 is mainly provided on the stepped portion 214 side of the virtual line L1. When the stepped portion 214 is provided only at a position facing one lateral surface of the two lateral surfaces of the light emitting element 220 that meet the light extraction surface, and the wire 270 is concentrated on the one lateral surface side of the light emitting element 220 as described above, it is possible to miniaturize the light emitting device 200.

The light emitting device 200 includes a plurality of the wires 270. The plurality of wires 270 include a wire 270 in which the joint portion of one of the two ends of the wire 270 is joined to the stepped portion 214 and the joint portion of the other end of the wire 270 is joined on the submount 230 at a position farther from the stepped portion 214 than the virtual line L1.

For the electrical connection between the light emitting element 220 and an external power source, the metal film provided on the lower surface of the package 210 can be used, for example. Thus, the light emitting element 220 and the external power source can be electrically connected via the metal film of the upper surface 212a of the frame portion 212 electrically connected to the metal film 215 via a metal material provided in a via hole.

The optical member 240 is disposed on the base portion 211. The optical member 240 is disposed on the upper surface 211a of the base portion 211. The optical member 240 includes the first lateral surface 241c on which light emitted from the light extraction surface of the light emitting element 220 is incident, and the upper surface 241a through which light exits. The light transmitting portion 241 of the optical member 240 is disposed at a position where the virtual line L1 passes, in a top view, for example. The upper surface 241a of the light transmitting portion 241 may be symmetric with respect to the virtual line L1. Further, the upper surface of the light reflecting portion 242 may be symmetric with respect to the virtual line L1. The virtual line L1 coincides with the optical axis of the light emitting element 220, passes through the center of the light transmitting portion 241, and intersects one of the inner lateral surfaces 212c of the frame portion 212, in a top view, for example.

The light emitted from the light emitting element 220 travels toward the optical member 240, passes through the opening defined by the opening 242x of the light reflecting portion 242, and is incident on the first lateral surface 241c of the light transmitting portion 241. The opening 242x can be regarded as defining the opening that causes the light emitted from the light extraction surface of the light emitting element 220 to be incident on the first lateral surface 241c. Light is emitted from the upper surface 241a of the light transmitting portion 241 on the basis of the light incident on the first lateral surface 241c. As used herein, the term "light emitted on the basis of the incident light" refers to, for example, incident light and, for example, light that has been wavelength-converted from the incident light.

The light extraction surface of the light emitting element 220 opposes the first lateral surface 241c of the light transmitting portion 241. The light extraction surface of the light emitting element 220 is parallel to the first lateral surface 241c of the light transmitting portion 241, for example. A height of the upper surface 214a of the stepped portion 214 is less than a height of the upper surface 241a of the light transmitting portion 241, with respect to the upper surface 211a of the base portion 211, for example. When the upper surface 214a has such a height, the stepped portion 214 is not directly irradiated with the light emitted upward from the upper surface 241a.

In a case in which the light transmitting portion 241 is a wavelength conversion portion, the light (first light) emitted from the light emitting element 220 is incident on the first lateral surface 241c of the light transmitting portion 241 and is converted to light (second light) having a wavelength different from that of the first light by the wavelength conversion portion. The first light incident on the first lateral surface 241c is emitted from the upper surface 241a. Further, the converted second light is emitted from the upper surface 241a. The first light and the second light are emitted upward from the upper surface 241a of the light transmitting portion 241. With the wavelength conversion member having a light incident surface on the lateral surface and a light extraction surface on the upper surface as described above, it is possible to realize lateral-to-upward optical path conversion and wavelength conversion. This allows for miniaturizing the light emitting device 200 to a greater extent than when, for example, the optical path is converted by a mirror and a member is separately disposed for converting the wavelength by a phosphor.

The first light and/or the second light is reflected at the light reflecting portion 242, travels toward the upper surface 241a of the light transmitting portion 241, and is emitted from the upper surface 241a of the light transmitting portion 241. As a result, it is possible to efficiently emit light from the upper surface 241a.

The reflective film 245 that transmits light emitted from the light emitting element 220 and reflects light wavelength-converted by the wavelength conversion portion can be provided on the first lateral surface 241c. With this reflective film 245, the light wavelength-converted by the wavelength conversion portion can be efficiently emitted from the upper surface 241a. Further, the metal film 244 provided on the lower surface of the light transmitting portion 241 serves as a light reflecting film that reflects the first light and the second light.

The cover portion 213 is disposed on the upper surface 212a of the frame portion 212. Specifically, the cover portion 213 is supported by the upper surface 212a of the frame portion 212, and is disposed above the light emitting element 220 surrounded by the frame portion 212. An outer peripheral portion of the lower surface of the cover portion 213 is joined to, for example, the upper surface 212a of the frame portion 212. For example, the metal film disposed on the outer peripheral portion of the lower surface of the cover portion 213 and the metal film disposed on the upper surface 212a of the frame portion 212 are joined and fixed via Au-Sn or the like.

The cover portion 213 is joined to the upper surface 212a of the frame portion 212, forming a closed space in which the light emitting elements 220 are disposed. This closed space is formed in a hermetically sealed state. By being hermetically sealed, collection of dust such as organic substances on the light extraction surface of the light emitting element 220 can be reduced.

The cover portion 213 includes the light-transmissive portion 213t that transmits and allows light emitted from the upper surface 241a of the light transmitting portion 241 to exit to the outside. That is, the light emitted from the upper surface 241a of the light transmitting portion 241 toward the cover portion 213 is transmitted through the light-transmissive portion 213t of the cover portion 213 and emitted outside the light emitting device 200. The entire cover portion 213 formed by the main material may be a light-transmissive portion. The light-transmissive portion 213t of the cover portion 213 preferably transmits 50% or greater, more preferably 70% or greater, of the light emitted from the light emitting element 220 and the light emitted from the optical member 240.

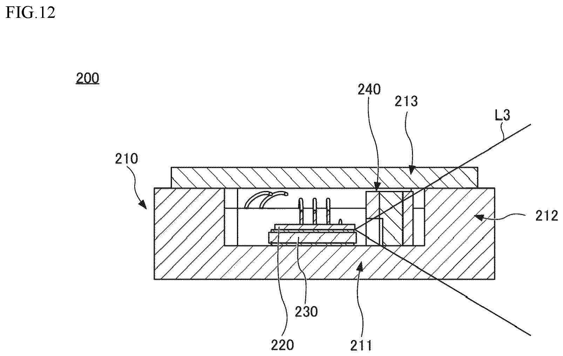

In the light emitting device 200, the frame portion 212 includes a light shielding portion that shields light in the same wavelength range as the light emitted from the light emitting element 220. As illustrated in FIG. 12, the light shielding portion of the frame portion 212 is located on an extending line L3 of an uppermost optical path of a main portion of light emitted from the light extraction surface of the light emitting element 220, the uppermost optical path being an optical path that extends most upwardly between emission from the light extraction surface to incidence on the optical member 240.

The light-transmissive portion 213t of the cover portion 213 is not disposed on a line segment on the extending line L3 of the uppermost optical path of the main portion of light emitted from the light extraction surface of the light emitting element 220, the line segment being a portion between the light extraction surface of the light emitting element 220 and a plane through which an inner lateral surface of the light shielding portion of the frame portion 212 facing the light extraction surface extends. With this arrangement, even if light from the light emitting element 220 travels without passing through the optical member 240 due to some cause, this light is directly incident on the light shielding portion of the frame portion 212 or the light shielding portion 213s of the cover portion 213, making it possible to prevent the light from being directly emitted from the light-transmissive part 213t of the cover portion 213.

The cover portion 213 is not disposed on a line segment on the extending line L3 of the uppermost optical path of the main portion of light emitted from the light extraction surface of the light emitting element 220, the line segment being a portion between the light extraction surface of the light emitting element 220 and the light shielding portion of the frame portion 212. With this arrangement, even if light from the light emitting element 220 travels without passing through the optical member 240 due to some cause, this light is directly incident on the light shielding portion of the frame portion 212, making it possible to prevent the light from being directly emitted from the light-transmissive part 213t of the cover portion 213.

The main portion of light defining the extending line L3 here is desirably light having an intensity of 1/e² times or greater of a peak intensity value, but may be light having an intensity of 1/2 times or greater the peak intensity value.

For example, in FIG. 11, a portion including the inner lateral surface 212c intersecting the virtual line L1 is the light shielding portion of the frame portion 212. The light shielding portion of the frame portion 212 does not transmit at least 90% of light in the same wavelength range as the light emitted from the light emitting element 220. It is preferable that the light shielding portion of the frame portion 212 does not transmit 95% or greater, more preferably does not transmit 99% or greater, of light in the same wavelength range as the light emitted from the light emitting element 220. Absorbing light is one preferred means of not transmitting light.
In a case in which the light is absorbed, the light is preferably absorbed at the percentages described above. The entirety of the frame portion 212 formed of the main material may be the light shielding portion.

Thus, in the light emitting device 200 including the optical member 240 as the wavelength conversion member, the light emitted laterally from the light emitting element 220 is directly incident on the light transmitting portion 241 of the optical member 240 without optical path conversion. Therefore, other members are not disposed between the light emitting element 220 and the light transmitting portion 241, unlike a structure in which light emitted laterally from a light emitting element is converted to an upward optical path by a light reflecting member and incident on a light transmitting portion. Thus, it is possible to miniaturize the light emitting device 200.

Further, in light emitting devices in the related art, there are devices that include, out of consideration for safety, a destruction detection control mechanism that turns off the light emitting element when the light transmitting portion is damaged. In contrast, in the light emitting device 200, the light emitted laterally from the light emitting element 220 is directly incident on the light transmitting portion 241 of the optical member 240 without optical path conversion. Therefore, even if the light transmitting portion 241 is damaged and the light emitted laterally from the light emitting element 220 is not incident on the light transmitting portion 241, the light strikes the light shielding portion of the frame portion 212 positioned on the optical path of the light emitted laterally from the light emitting element 220, and is absorbed by the light shielding portion, thus being prevented from being emitted outside the light emitting device 200. As a result, safety can be sufficiently ensured without providing a destruction detection control mechanism that turns off the light emitting element 220 when the light transmitting portion 241 is damaged. That is, miniaturization of the light emitting device 200 in which safety is ensured can be achieved.

Further, in the light emitting device 200, the stepped portion 214 is provided at a position facing one lateral surface of the two lateral surfaces of the light emitting element 220 that meet the light extraction surface, and a stepped portion is not provided at a position facing the other lateral surface of the two lateral surfaces. Further, the light emitting element 220 is disposed in the center of the frame defined by the upper surface 212a of the frame portion 212 in a direction parallel to the light extraction surface of the light emitting element 220, in a top view. Thus, the light emitting device 200 of a small size can be realized while the light emitting element 220 is located at the center.

In a case in which the light transmitting portion 241 is not a wavelength conversion unit, light incident on the light transmitting portion 241 from the light emitting element 220 is repeatedly reflected at the light reflecting portion 242 and is emitted from the upper surface 241a of the light transmitting portion 241. Further, in a case in which wavelength conversion is not necessary, the optical member 240 need not be configured to include the light transmitting portion 241 and the light reflecting portion 242. For example, the optical member 240 may be a mirror including an inclined surface on which the light entered from the light emitting element 220 is reflected toward the cover portion 213. Alternatively, the optical member 240 may be a microelectromechanical systems (MEMS) mirror that deflects and scans the light incident from the light emitting element 220 toward the cover portion 213.

The light emitting device 200 can be used, for example, for an on-vehicle headlight. Other than this, the light emitting device 200 can be used for illumination, a projector, a head-mounted display, and a light source such as a backlight of other displays.

Although preferred embodiments and the like have been described in detail above, the disclosure is not limited to the above-described embodiments and the like, various modifications and substitutions can be made to the above-described embodiments and the like without departing from the scope described in the claims.

## Claims

1. A light emitting device comprising:
a package comprising a base portion, a frame portion, and a cover portion;
a light emitting element disposed on an upper surface of the base portion, surrounded by the frame portion, and configured to emit light traveling laterally; and
a wavelength conversion member disposed on the base portion and including a first lateral surface on which light emitted from a light extraction surface of the light emitting element is to be incident, and an upper surface through which light is to be emitted; wherein:
the frame portion comprises a light shielding portion configured to shield light in a wavelength range of the light emitted from the light emitting element;
the cover portion comprises a light-transmissive portion configured to transmit and cause light emitted from the upper surface of the wavelength conversion member to exit to an area outside the light emitting device;
the light shielding portion is located on an extending line of an uppermost optical path of a main portion of light emitted from the light extraction surface, the uppermost optical path being an optical path that extends most upwardly between emission from the light extraction surface to incidence on the wavelength conversion member, and
the light-transmissive portion is not disposed on a line segment on the extending line of the uppermost optical path of the main portion of light, the line segment being a portion between the light extraction surface and the light shielding portion.

2. The light emitting device according to claim 1, wherein:
the package further comprises a stepped portion including an upper surface having a height greater than that of an upper surface of the base portion and less than that of an upper surface of the frame portion;
a metal film is located on the upper surface of the stepped portion; and
the light emitting element is electrically connected to the metal film via a wire.

3. The light emitting device according to claim 2, wherein:
the stepped portion is provided at a position facing one lateral surface of two lateral surfaces of the light emitting element that meet the light extraction surface, and is not provided at a position facing the other lateral surface.

4. The light emitting device according to claim 2 or 3, further comprising:
a submount on which the light emitting element is located; wherein:
in a top view, in a direction parallel to the light extraction surface, a distance between the light emitting element and the stepped portion is less than a distance between a center of the submount and the stepped portion.

5. The light emitting device according to claim 4, wherein:
in a top view, the light emitting element is disposed at a position through which a virtual line extends, the virtual line being orthogonal to the light extraction surface and passing through a center of two points of intersection between a plane in which the light extraction surface extends and a frame defined by the upper surface of the frame portion.

6. The light emitting device according to any one of claim 1 to 5, wherein:
the wavelength conversion member comprises:
a wavelength conversion portion including the first lateral surface and an upper surface through which the light is emitted, and
a light reflecting portion covering at least all lateral surfaces other than the first lateral surface of the wavelength conversion portion.

7. The light emitting device according to claim 6, wherein:
the light reflecting portion further covers a portion of the first lateral surface, and includes an opening defining an opening that causes the light emitted from the light extraction surface to be incident on the first lateral surface.

8. The light emitting device according to claim 7, wherein:
the light reflecting portion upwardly and laterally covers a region of the first lateral surface where light from the light emitting element is incident.

9. The light emitting device according to any one of claim 6 to 8, wherein:
the wavelength conversion portion contains a phosphor.

10. The light emitting device according to any one of claim 6 to 9, wherein:
each of the wavelength conversion portion and the light reflecting portion is a sintered body and is made of a ceramic as a main material.

11. The light emitting device according to claim 10, wherein:
the wavelength conversion portion and the light reflecting portion are integrally formed.

12. The light emitting device according to any one of claim 6 to 11, further comprising:
a reflective film located on the first lateral surface and configured to transmit light emitted from the light emitting element and reflect light wavelength-converted by the wavelength conversion portion.

13. The light emitting device according to any one of claim 1 to 12, further comprising:
an anti-reflective film on the upper surface of the wavelength conversion member.

14. The light emitting device according to any one of claim 1 to 13, further comprising:
a light reflecting film on a lower surface of the wavelength conversion member.
